(19) Europäisches Patentamt

European Patent Office

Office européen des brevets

(11) **EP 1 393 403 B1**

(12) **EUROPEAN PATENT SPECIFICATION**

(45) Date of publication and mention
of the grant of the patent:
**30.08.2006 Bulletin 2006/35**

(51) Int Cl.:
*H01P 1/18* (2006.01)    *H04B 1/30* (2006.01)

(21) Application number: **02720351.2**

(22) Date of filing: **10.04.2002**

(86) International application number:
**PCT/IB2002/001143**

(87) International publication number:
**WO 2002/084778 (24.10.2002 Gazette 2002/43)**

(54) **TUNABLE PHASE SHIFTER AND APPLICATIONS FOR SAME**

ABSTIMMBARER PHASENSCHIEBER UND ANWENDUNGEN DAFÜR

DEPHASEUR ACCORDABLE ET SES APPLICATIONS

(84) Designated Contracting States:
**AT BE CH CY DE DK ES FI FR GB GR IE IT LI LU MC NL PT SE TR**

(30) Priority: **11.04.2001 US 283093 P**
**13.07.2001 US 904631**
**24.07.2001 US 912753**
**08.08.2001 US 927732**
**10.08.2001 US 927136**

(43) Date of publication of application:
**03.03.2004 Bulletin 2004/10**

(73) Proprietor: **Kyocera Wireless Corp.**
**San Diego, CA 92121 (US)**

(72) Inventors:
• **TONCICH, Stanley, S.**
**San Diego, CA 92131 (US)**

• **WALLACE, Raymond, Curtis**
**San Diego, CA 92103 (US)**

(74) Representative: **Viering, Jentschura & Partner**
**Steinsdorfstrasse 6**
**80538 München (DE)**

(56) References cited:
EP-A- 0 473 373      WO-A-00/24079
US-A- 5 293 408      US-A- 5 416 803
US-A- 5 479 139      US-B1- 6 216 020

• ERKER E G ET AL: "MONOLITHIC KA-BAND PHASE SHIFTER USING VOLTAGE TUNALBLE BASRTIO3 PARALLEL PLATE CAPACITORS" IEEE MICROWAVE AND GUIDED WAVE LETTERS, IEEE INC, NEW YORK, US, vol. 10, no. 1, January 2000 (2000-01), pages 10-12, XP000930368 ISSN: 1051-8207

**Description**

**BACKGROUND**

**Field of the Invention**

The field of the present invention is electronics. More particularly, the present invention relates to direct conversion receivers in wireless communication devices.

**Description of Related Art**

Most present wireless communication devices use transceivers (transmitters and receivers) that have an intermediate frequency (IF) stage between the baseband and the radio frequency (RF) stages. Transceivers with an IF stage are called superheterodyne transceivers. The compelling commercial drive for cheaper, more reliable, longer lasting and smaller wireless communication devices is causing many in the industry to attempt to eliminate the IF stage. This would produce a saving in number of components, cost and size.

Transceivers without IF stages are called direct down conversion transceivers, since the RF signal is converted directly to a baseband signal from the RF signal. They are also known as zero IF transceivers.

Since a superheterodyne receiver does have an intermediate frequency stage, a superheterodyne,receiver will generally have more components compared to a direct downconversion receiver. Currently, most wireless handsets are made with superheterodyne transceivers (transmitter and receiver) since the use and manufacture of superheterodyne receivers is well understood. Although most handsets use a superheterodyne design, such use is in tension with the ever-present concern of reducing the size of handsets and lowering their cost of manufacture because of the hardware needed for the intermediate frequency stage.

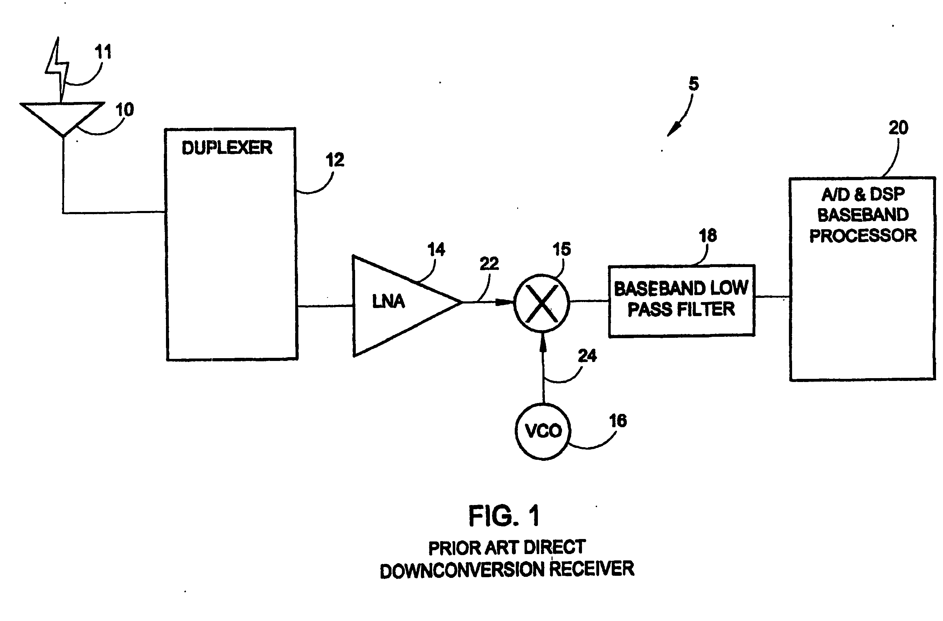

The use of direct-conversion technology in wireless handsets would obviate the need for an intermediate frequency stage, thereby reducing manufacturing cost and size limitations. However, a number of problems have prevented the widespread use of direct conversion technology in wireless handsets. For example, consider Figure 1 showing a prior art direct downconversion receiver 5. The receiver 5 includes an antenna 10 to receive a transmitted radio-frequency (RF) signal 11. RF signal 11 couples through a duplexer 12 to a low noise amplifier 14. The amplified RF signal then couples to a mixer 15 through RF port 22. The amplified RF signal is typically a bandpass signal, $g_{bp}(t)$, that may be represented as

$$g_{bp}(t) = g_c(t)\cos w_0 t + g_s(t)\sin w_0 t$$

where $g_c(t)$ and $g_s(t)$ are the in-phase (I) and quadrature (Q) components of the baseband signal, respectively. Thus, to convert this bandpass signal to its baseband components, a voltage-controlled oscillator 16 produces a sinusoid at the RF frequency $w_0$ to couple into the mixer 15 through LO port 24. A baseband low pass filter 18 recovers the baseband components, which are then processed by an A/D and digital-signal-processor (DSP) baseband processor 20.

Note that the mixer receives sinusoids at the same frequency, $w_0$, at both its ports 22 and 24. Thus, unlike a mixer in the IF stage of a superheterodyne receiver, serious coupling side effects can occur in the mixer 15. These effects include non-linear effects of the mixer producing unwanted harmonics of the baseband signal. In addition, a DC offset may be present in the demodulated baseband signal due to leakage of the VCO's sinusoid output into RF port 22 of mixer 15. This type of leakage is particularly problematic because the VCO output is typically many decibels higher in power than the output of the low noise amplifier 15. Moreover, this type of leakage is exacerbated at the higher frequencies, such as the PCS band, used in wireless handsets.

Given an LO leakage, a sinusoid output at frequency w1 from the VCO 16 entering LO port 24 will also couple into RF port 22. The same signal is thus present at both RF port 22 and LO port 24 and will be squared by mixer 15. Regardless of the phase of the input sinusoid, its squaring produces a sinusoid of double the input frequency and a DC offset term. Thus, LO leakage necessarily produces a DC offest. A number of techniques have been developed to address the problem of LO leakage and the resulting distortion and DC offset in the demodulated baseband signal. For example, U.S. Pat. Nos. 4,811,425 and 5,001,773 disclose schemes to directly cancel the LO component entering RF port 22 of mixer 15. Because the LO component entering RF port 22 is necessarily of smaller amplitude than the LO signal produced by VCO 16, a cancelling signal must be appropriately scaled and phase-shifted to cancel the leaking LO component. These direct cancellation schemes suffer from the expensive hardware necessary and poor efficiency at cancelling the leakage component.

European Pat. App. No. EP 0 473 373 A2 discloses a built-in-test function, used on a discontinuous basis, to calibrate a radio broadcast direct conversion receiver having a plurality of channels (i.e., AM radios) to correct inevitable variations between the amplifiers, filters,- and other equipment that make up these signal channels. This built-in-test function is selectable over normal antenna reception, and reestablishes normal broadcast reception once calibration is complete.

Accordingly, there is a need in the art for improved apparatus and techniques for reducing local oscillator leakage effects in direct downconversion receivers.

## SUMMARY

It is desirable to provide a direct downconversion receiver that reduces DC offset in its demodulated baseband signal. It is therefore an object of the invention to provide a methodology for adaptively adjusting the receiver's characteristics in response to detected DC offset.

In accordance with one aspect of the invention, a tunable, low loss, phase shifting filter is provided. The filter may be configured as a low pass filter, a high pass filter or an all pass filter. The filter includes a variable dielectric constant ferro-electric component.

In accordance with another aspect of the invention, a direct downconversion receiver has a DC offset detector for detecting a DC offset in a received baseband signal and providing a negative feedback signal proportional to the detected DC offset. A tunable filter adjusts the phase of the receiver's local oscillator signal according to the negative feedback signal. A mixer mixes a received RF signal with the phase-shifted local oscillator signal to produce the baseband signal. Because of the negative feedback loop formed by the DC offset detector, tunable filter, and mixer, the amount of DC offset in the baseband signal is reduced.

In accordance with another aspect of the invention, a method is provided for reducing DC offset in a direct downconversion receiver. In this method, a received RF signal is mixed with a phase-shifted local oscillator signal to produce a directly downconverted baseband signal. A DC offset in the baseband signal is detected and the phase-shift in the phase-shifted local oscillator signal is adjusted to reduce the DC offset.

Further aspects and features of the invention are set forth in the following description together with the accompanying drawings.

## BRIEF DESCRIPTION OF THE DRAWINGS

FIG. 1 is a block diagram of a prior art direct down conversion receiver.
FIG. 2 is a block diagram of a direct down conversion receiver configured to provide DC offset reduction according to one embodiment of the invention.
FIG. 3 illustrates a tunable high pass filter suitable for use in the direct downconversion receiver of FIG. 2.
FIG. 4 illustrates the phase delay variation for the tunable filter of FIG. 3.
FIG. 5 shows a schematic diagram of a feedback network.

Use of the same reference symbols in different figures indicates similar or identical items.

## DETAILED DESCRIPTION

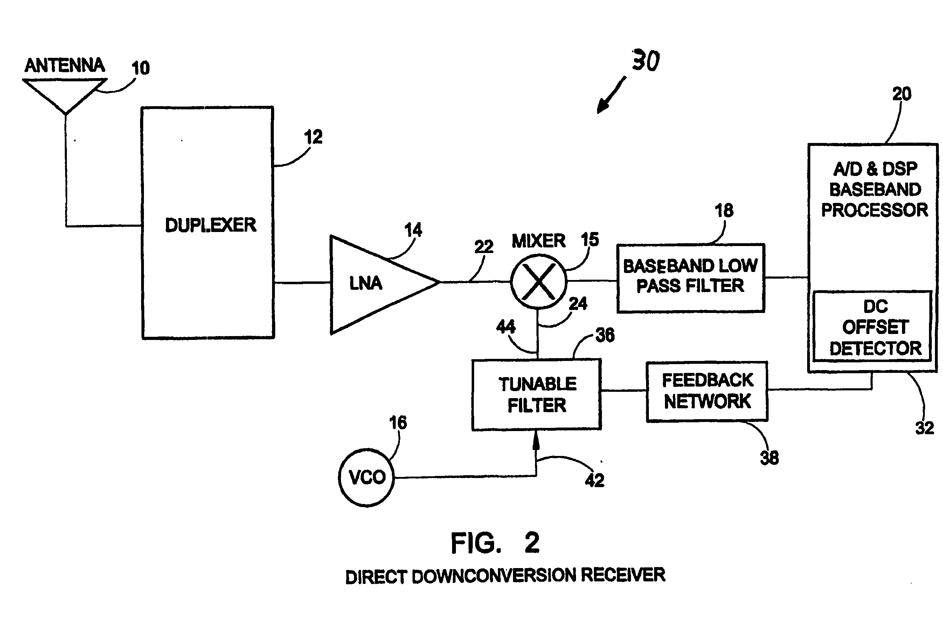

Referring now to Figure 2, a phase-compensated direct downconversion receiver 30 is illustrated. As discussed with respect to Figure 1, downconversion receiver 30 may include antenna 10, duplexer 12, low noise amplifier 14, mixer 15, VCO 16, baseband low pass filter 18, and A/D & DSP baseband processor 20. In addition, baseband processor 20 includes a DC offset detector 32. Although shown integrated with baseband processor 20, DC offset detector 32 may be distinct from baseband processor 20. It will be appreciated that DC offset detector 32 may be implemented in hardware or software or a combination of the two in a number of ways.

Regardless of the implementation, DC offset detector 32 functions to provide a measure of the amount of DC offset present in the demodulated baseband signal recovered by baseband processor 20. For example, DC offset detector 32 could average or low pass filter the waveform produced by the analog-to-digital converter (A/D) within baseband processor 20. DC offset detector 32 could then be implemented in a microprocessor or state machine programmed to keep a running average of the A/D converter's waveform. If there is no DC offset, the average of this waveform should be approximately zero in that, over time, the positive samples would tend to cancel the negative samples produced in the digitized waveform coming from the A/D converter. The DC offset would tend to bias the signal high or low. Feedback network 38 would receive the digital DC offset measurement from DC offset detector 32. Based on this value, feedback network 38 incrementally adjusts the value of $V_{f\text{-}e}$ applied to tunable filter 36. Feedback network 38 retains a memory of the value of DC offset measurement. If the next measurement of DC offset received by feedback network 38 from DC offset detector 32 is larger in magnitude than the preceding value, feedback network 38 reverses directions and sets the value of $V_{f\text{-}e}$ to a value on the opposite side of the initial value of Vf-e. If, however, the next measurement of DC offset received by feedback network 38 from DC offset detector 32 is smaller in magnitude than the preceding value, feedback network 38 maintains the direction of change in $V_{f\text{-}e}$ and increments $V_{f\text{-}e}$ again.

Alternatively, one could design the system to initially operate without an RF input to detect the DC offset preset. This DC offset could be subtracted out. This will work if the time variation of the DC offset is quite small relative to the sampling period of the DC offset detector and the feedback network. Alternatively, DC offset detector 32 would simply be provided by signal quality metrics already provided in a conventional receiver such as a wireless handset. For example, SINAD which is the ratio of the demodulated baseband signal strength to all noise and interfering signals could be used. As SINAD dipped below a pre-determined threshold, DC offset could be presumed to be present.

Regardless of how the DC offset is detected by DC offset detector 32, DC offset detector 32 will generate a feedback signal proportional to the amount of DC offset. This feedback signal may be either analog or digital. For example, if DC offset detector 32 is a microprocessor performing a running average of the digitized waveform produced by baseband processor's 20 A/D converter, DC offset detector could just scale the running average into an appropriate digitized value. The amount of scaling appropriate will be determined by consideration of the characteristics of a tunable filter 36 that couples to the feedback signal through a feedback network 38. Tunable filter 36 may be an all-pass, a low pass or a high-pass filter that adjusts the phase of the local oscillator signal produced by VCO 16. Tunable filter 36 adjusts the phase responsive to the feedback signal coupled through negative feedback network 38. As stated above, tunable filter 36 could even be a low pass filter, should its corner frequency be high enough with respect to the frequency of the local oscillator signal. Because the local oscillator signal produced by VCO 16 is normally a narrowband sinusoid, the type of tunable filter 36, whether all-pass, high-pass, or even low-pass, is not important so long as the local oscillator signal will pass through tunable filter 36 with enough amplitude to function in mixer 15 to downconvert the amplified received RF signal entering the mixer's RF port 22.

A key advantage of the present invention is that the amplitude of the signal produced by tunable filter 36 is not important. In other words, unlike the prior art DC offset reduction schemes discussed previously, direct downconversion receiver 30 need only control the phase of local oscillator signal with respect to feedback from DC offset detector 32. In contrast, because the previously-discussed prior art schemes served to directly cancel the LO leakage entering RF port 22, these schemes had to adjust both the phase and amplitude of the LO leakage cancelling signal. The difficulty of matching both these signal characteristics leads to the poor DC offset cancellation efficiency of such schemes.

Tunable filter 36, responsive to the presence of a DC offset feedback signal produced by negative feedback network 38, adjusts the phase of the local oscillator signal produced by VCO 16. It will be appreciated that many different types of tunable filters 36 may be implemented that will suitably adjust the phase of the local oscillator signal. Importantly, however, the tunable filter 36 will be near LO port 24 of mixer 15. Filter 36 should be near LO port 24, so that there is not a lot of transmission line that can leak into port 22. Note that VCO 16 will typically provide a local oscillator signal not just to mixer 15 but will couple the LO signal to multiple locations throughout receiver 30. For example, in a wireless handset, VCO 16 may be several inches away from mixer 15 and the local oscillator signal distributed on several traces or leads on the wireless handset's motherboard. In this fashion, the local oscillator signal may radiate from the inch or greater in length lead from VCO 16 to mixer 15 as well as the other leads carrying the local oscillator signal. This gives ample opportunity for the local oscillator signal to reactively couple or radiate into RF port 22 of mixer 15. Such reactive coupling and radiation is facilitated by the relatively high (1-2 GHz) frequencies employed in modern digital handsets. In contrast, however, tunable filter 36 is preferably as close as possible to mixer 15 so as to minimize any reactive coupling of the phase-adjusted local oscillator signal produced by tunable filter 36 into RF port 22 of mixer 15. This is important because the phase-shifted local oscillator signal produced by tunable filter 36 cannot cancel itself - should it reactively couple into RF port 22 of mixer 15, it will be mixed with itself. As discussed previously, the resulting squaring of a sinusoid, in this case the phase-shifted local oscillator signal, will produce a DC offset term. Locating tunable filter 36 adjacent LO port 24 of mixer 15 will minimize this squaring of its phase-shifted output signal in mixer 15, thereby preventing an undesired DC offset in the demodulated baseband signal produced by baseband processor 20.

The phase-shifted local oscillator signal from tunable filter 36 will be mixed or multiplied with the amplified received RF signal and any LO leakage signal resulting from reactive coupling or radiation of the local oscillator signal into RF port 22. Because of the multiplication, tunable filter's 36 phase-shifted output can cancel the LO leakage signal regardless of the phase-shifted local oscillator signal's amplitude. As will be appreciated by those of ordinary skill in the art, many types of tunable filter architectures may be implemented in the present invention.

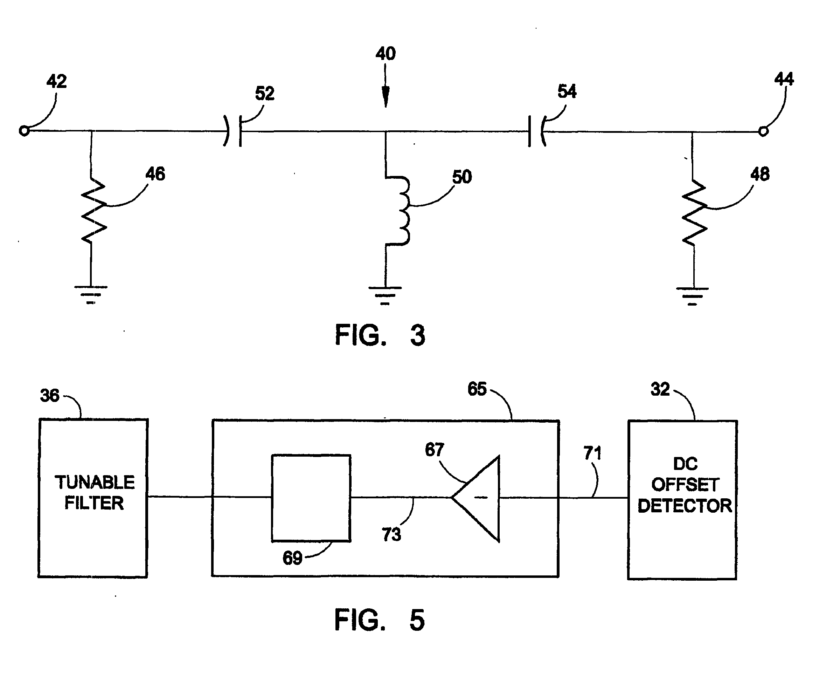

Figure 3 illustrates a high pass tunable filter 40 tuned to 2.0 GHz that will phase shift a local oscillator signal as one embodiment of tunable filter 36. As is customary in the art, the input 42 and output 44 of tunable filter 40 are matched to a 50 Ω impedance as symbolized by resistors 46 and 48. Of course, it will be appreciated that this assumes LO input port 24 and VCO 16 are tuned to have matching 50 Ω impedances. Regardless of the actual impedance involved, the components should be adjusted for matching output and input impedances for maximum efficiency. Any impedance elements can be used. An impedance element is defined herein as any element having an impedance, such as, for example, a capacitor, an inductor, a resistor, a transmission line, etc.

Inductor 50 may have an inductance of 4.0 nH. The tunable elements are capacitors 52 and 54. In this embodiment, capacitors 52 and 54 are identical and may be tuned over a range of 1 to 4 pF in capacitance. Because of the resulting symmetry, ports 42 and 44 are equivalent and may be denoted as either input or output ports.

Ferroelectric (f-e) material is used to form capacitors 52 in a variety of topologies such as gap, overlay, or interdigital. The principle advantage of using f-e capacitors in the range of 1 to 2 GHz is that they can provide lower loss than other tunable components, such as, for example, varactor diodes. Any phase shifting network used in such an application should preferably provide the lowest possible RF loss. System performance is degraded when the local oscillator (LO) drive level is reduced. Furthermore, many mixers require a minimum LO drive level to satisfy mixer gain and loss requirements, depending on whether the mixer is active or passive. Added loss in the LO path requires an increased LO drive level, thus increasing current draw in the battery as well as providing a higher level signal to leak into the RF path.

Further details of designing a suitable tunable f-e capacitor may be found in co-pending U.S. Patent Applications US 2002/0158717; US 2002/0163400; US 2002/0149448; US 2002/0175878; and US 2002/0149444.

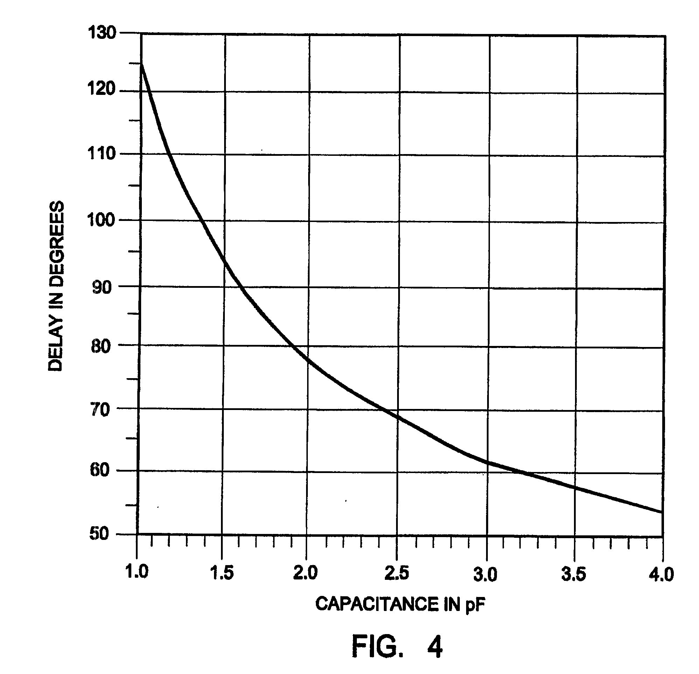

Regardless of how capacitors 52 and 54 are formed, the resulting phase response of filter 40 is shown in Figure 4. This phase variation exists between an input sinusoid at 2.0 GHz entering port 42 and a phase-shifted sinusoid exiting port 44. When capacitors 52 and 54 have a capacitance of 1.0 pF, the phase delay through filter 40 is 125 degrees. Tuning capacitors 52 and 54 to a capacitance of 4.0 pF adjusts the phase delay to approximately 53 degrees. The relationship of ports 42 and 44 to LO port 24 and VCO 16 may be seen in Figure 2. It will be appreciated that the range of phase variation necessary from tunable filter 36 will depend upon a case-by-case analysis of the DC offset present in a given receiver. Should additional phase variation be needed, filter 40 may include additional capacitors and inductors. Alternatively, a resistor-capacitor topology may be used. That is, a low pass filter made out of resistor and capacitors may be used.

Referring to Fig. 2, a control signal generator (not shown) generates a control signal for tuning the ferroelectric component or components.

A distributed architecture may also be used to form filter 36, such as a tunable transmission line whose electrical length is adjusted according to a feedback signal. For example, a ferro-electric (f-e) loaded microstrip line may be used. Such a devices and methods are described in a U.S. Patent Application US 2002/0175878.

Feedback network 38 serves to provide a negative feedback signal to tunable filter 36. In the embodiment shown in Fig. 2, feedback network 38 serves as the control signal generator. Regardless of the particular implementation of feedback network, one of ordinary skill will appreciate that fundamental principles govern the resulting stability of the negative feedback loop. In any negative feedback loop, an output is used to cancel an input. In this case, the output is the resulting phase variation from tunable filter 36 that is used to cancel the input, the DC offset detected by DC detector 32. To be stable, the transfer function must not have any root in the right half of the s-plane. The transfer function is ratio of the Laplace transform of the output and input under zero initial conditions.

A specific example of how the feedback network can be implemented will now be given. Fig. 5 shows a schematic diagram of a feedback network 65. The feedback network 65 contains an inverting operational amplifier 67 whose output 73. is coupled to a scaling system 69. The operational amplifier 67 receives its input 71 from the DC offset detector 32. The operational amplifier 67 inverts this input and may also amplify or attenuate it for scaling system 69.

At the output 73 to operational amplifier 67, the signal may be positive or negative. Preferably, tunable filter 36 receives a non-negative signal. Thus, scaling system 69 shifts output 73 by adding a voltage to output 73 equal to or greater than the maximum absolute value of the likely output signal 73. Scaling system 69 may also amplify output 73, after adding a voltage to it. Thus, for example, output 73 may range from - 0.8 V to +0.8 V and scaling system 69 may shift it to 0.0 V to +1.6 V and then scaling it to 0.0 V to 3.3 V.

Scaling system 69 is coupled to tunable filter 36 for tuning tunable filter 36. Advantageously, tunable filter 36 varies the phase of the LO signal, responsive to the DC offset signal, thereby minimizing the DC offset of the baseband signal.

Alternatively, feedback network may be implemented as a state machine. In this case, DC offset signal is preferably a digital signal. In the interest of brevity, the functioning of state machines will not be described here.

Although the invention has been described with reference to particular embodiments, the description is only an example of the invention's application and should not be taken as a limitation. Consequently, various adaptations and combinations of features of the embodiments disclosed are within the scope of the invention as encompassed by the following claims.

## Claims

1. A system for correcting baseband signal DC offset generated by a direct downconversion receiver (30) in a wireless communication device, the system comprising:

   a mixer (15) comprising an input (22) to receive a wireless communications signal (11) and an input (24) to receive a downconversion signal;
   a local oscillator (16) to provide a reference signal;
   wherein the system is **characterized by**:

   a DC offset detector (32) comprising an input to receive a baseband signal and an output to provide a DC offset signal indicative of a DC offset of the baseband signal;
   a feedback network (38, 65) coupled to the DC offset detector (32) comprising an input (71) to receive the DC offset signal and an output to provide a control signal; and
   a tunable phase shifting filter (36, 40) coupled to the feedback network (38, 65), the local oscillator (16), and the mixer (15); the filter (36, 40) comprising: a first impedance element (52) comprising a first ferroelectric component and a second impedance element (50) coupled to the first impedance element (52), the first and second impedance elements (52, 50) configured to provide the downconversion signal by shifting the phase of the reference signal applied to either the first impedance element (52) or the second impedance element (50) in response to the control signal.

2. The system of claim 1, wherein the first ferroelectric component comprises a first ferroelectric capacitor.

3. The system of claim 2, wherein the first ferroelectric capacitor comprises a gap capacitor.

4. The system of claim 2, wherein the first ferroelectric capacitor comprises an overlay capacitor.

5. The system of claim 1, further comprising a third impedance element (54) comprising a second ferroelectric component.

6. The system of claim 5, wherein the first and second ferroelectric components comprise first and second ferroelectric capacitors.

7. The system of claim 6, wherein the first and second ferroelectric capacitors comprise gap capacitors.

8. The system of claim 6, wherein the first and second ferroelectric capacitors comprise overlay capacitors.

9. The system of claim 1, wherein the feedback network (38, 65) comprises an inverting amplifier (67).

10. The system of claim 1, wherein the feedback network (38, 65) comprises a state machine.

11. A method of correcting baseband signal DC offset generated by a direct downconversion receiver in a wireless communication device, the method comprising:

   mixing an RF signal received via an antenna (10) with a phase-shifted local oscillator signal to produce a directly downconverted baseband signal;
   detecting a DC offset in the directly downconverted baseband signal; and in response to the detected DC offset adjusting the phase-shift in the phase-shifted local oscillator signal using a tunable ferroelectric component (52,54) to reduce the detected DC offset, wherein the DC offset reduction and downconverted baseband signal production occur simultaneously.

## Patentansprüche

1. System zum Korrigieren des Basisbandsignal-Gleichstrom-Offsets, der durch einen Direkt-Abwärtswandlungs-Empfänger (30) in einer Funk-Kommunikationseinrichtung erzeugt wird, wobei das System aufweist:

   einen Mischer (15), der einen Eingang (22), um ein Funk-Kommunikationssignal (11) zu empfangen, und einen Eingang (24), um ein Abwärtswandlungssignal zu empfangen, aufweist;
einen Empfangsoszillator (16), um eine Referenzsignal zu liefern;
wobei das System **gekennzeichnet ist durch**:

einen Gleichstrom-Offset-Detektor (32), der einen Eingang, um ein Basisbandsignal zu empfangen, und einen Ausgang, um ein Gleichstrom-Offset-Signal zu liefern, das einen Gleichstrom-Offset des Basisbandsignals anzeigt, aufweist;

eine Rückkopplungsschaltung (38, 65), die mit dem Gleichstrom-Offset-Detektor (32) gekoppelt ist und einen Eingang (71), um das Gleichstrom-Offset-Signal zu empfangen, und einen Ausgang, um ein Steuersignal zu liefern, aufweist; und

einen abstimmbaren Phasenverschiebungsfilter (36, 40), der mit der Rückkopplungsschaltung (38, 65), dem Empfangsoszillator (16) und dem Mischer (15) gekoppelt ist; wobei der Filter (36, 40) aufweist: ein erstes ImpedanzElement (52), das eine erste ferroelektrische Komponente aufweist, und ein zweites Impedanzelement (50), das mit dem ersten Impedanzelement (52) gekoppelt ist, wobei das erste und das zweite Impedanzelement (52, 50) dazu konfiguriert sind, das Abwärtswandlungs-Signal **durch** Verschieben der Phase des Referenzsignals, das entweder an das erste Impedanzelement (52) oder das zweite Impedanzelement (50) angelegt ist, in Antwort auf das Steuersignal, zu liefern.

2. System nach Anspruch 1, wobei die erste ferroelektrische Komponente einen ersten ferroelektrischen Kondensator aufweist.

3. System nach Anspruch 2, wobei der erste ferroelektrische Kondensator einen Spaltkondensator aufweist.

4. System nach Anspruch 2, wobei der erste ferroelektrische Kondensator einen Overlay-Kondensator aufweist.

5. System nach Anspruch 1, das ferner ein drittes Impedanzelement (54) aufweist, das eine zweite ferroelektrische Komponente aufweist.

6. System nach Anspruch 5, wobei die erste und die zweite ferroelektrische Komponente einen ersten bzw. einen zweiten ferroelektrischen Kondensator aufweist.

7. System nach Anspruch 6, wobei der erste und der zweite ferroelektrische Kondensator Spalt-Kondensatoren aufweisen.

8. System nach Anspruch 6, wobei der erste und der zweite ferroelektrische Kondensator Overlay-Kondensatoren aufweisen.

9. System nach Anspruch 1, wobei die Rückkopplungsschaltung (38, 65) einen invertierenden Verstärker (67) aufweist.

10. System nach Anspruch 1, wobei die Rückkopplungsschaltung (38, 65) eine Zustandsmaschine aufweist.

11. Verfahren zum Korrigieren eines Basisbandsignal-Gleichstrom-Offsets, der durch einen Direkt-Abwärtswandlungs-Empfänger in einer Funk-Komunikationseinrichtung erzeugt wird, wobei das Verfahren aufweist:

Mischen eines Hochfrequenzsignals, das mittels einer Antenne (10) mit einem phasenverschobenen Empfangsoszillatorsignal empfangen wird, um ein direkt abwärtsgewandeltes Basisbandsignal zu erzeugen;
Detektieren eines Gleichstrom-Offsets in dem direkt abwärtsgewandelten Basisbandsignal; und in Antwort auf den detektierten Gleichstrom-Offset
Einstellen der Phasenverschiebung in dem phasenverschobenen Empfangsoszillatorsignal unter Verwendung einer abstimmbaren ferroelektrischen Komponente (52, 54), um den detektierten Gleichstrom-Offset zu vermindern, wobei die Verminderung des Gleichstrom-Offsets und die Erzeugung des abwärtsgewandelten Basisbandsignals gleichzeitig geschehen.

**Revendications**

1. Système permettant de corriger un décalage CC (composante continue) de signal de bande de base généré par un récepteur d'abaissement de fréquence direct (30) dans un dispositif de communication sans fil, le système comprenant :

un mélangeur (15) comprenant une entrée (22) pour recevoir un signal de communication sans fil (11) et une entrée (24) pour recevoir un signal d'abaissement de fréquence ;
un oscillateur local (16) permettant de fournir un signal de référence ;
dans lequel le système est **caractérisé par** :

un détecteur de décalage CC (composante continue) (32) comprenant une entrée pour recevoir un signal de bande de base et une sortie pour délivrer un signal de décalage CC indiquant un décalage CC du signal de bande de base ;
un réseau à rétroaction (38, 65) accouplé au détecteur de décalage CC (32) comprenant une entrée (71) pour recevoir le signal de décalage CC et une sortie pour délivrer un signal de commande ; et
un filtre à décalage de phase accordable (36, 40) accouplé au réseau à rétroaction (38, 65), à l'oscillateur local (16) et au mélangeur (15) ; le filtre (36, 40) comprenant : un premier élément d'impédance (52) comprenant un premier composant ferroélectrique et un deuxième élément d'impédance (50) accouplé au premier élément d'impédance (52), les premier et deuxième éléments d'impédance (52, 50) étant configurés pour délivrer le signal d'abaissement de fréquence en décalant la phase du signal de référence appliqué au premier élément d'impédance (52) ou au deuxième élément d'impédance (50) en réponse au signal de commande.

2. Système selon la revendication 1, dans lequel le premier composant ferroélectrique comprend un premier condensateur ferroélectrique.

3. Système selon la revendication 2, dans lequel le premier condensateur ferroélectrique comprend un condensateur à entrefer.

4. Système selon la revendication 2, dans lequel le premier condensateur ferroélectrique comprend un condensateur à recouvrement.

5. Système selon la revendication 1, comprenant en outre un troisième élément d'impédance (54) comprenant un deuxième composant ferroélectrique.

6. Système selon la revendication 5, dans lequel les premier et deuxième composants ferroélectriques comprennent des premier et deuxième condensateurs ferroélectriques.

7. Système selon la revendication 6, dans lequel les premier et deuxième condensateurs ferroélectriques comprennent des condensateurs à entrefer.

8. Système selon la revendication 6, dans lequel les premier et deuxième condensateurs ferroélectriques comprennent des condensateurs à recouvrement.

9. Système selon la revendication 1, dans lequel le réseau à rétroaction (38, 65) comprend un amplificateur inverseur (67).

10. Système selon la revendication 1, dans lequel le réseau à rétroaction (38, 65) comprend un automate fini.

11. Procédé permettant de corriger un décalage CC de signal de bande de base généré par un récepteur d'abaissement de fréquence direct dans un dispositif de communication sans fil, le procédé comprenant les étapes consistant à :

mélanger un signal RF reçu par l'intermédiaire d'une antenne (10) à un signal d'oscillateur local à décalage de phase afin de produire un signal de bande de base directement abaissé en fréquence ;
détecter un décalage CC dans le signal de bande de base directement abaissé en fréquence ; et en réponse au décalage CC détecté ;
ajuster le décalage de phase dans le signal d'oscillateur local à décalage de phase en utilisant un composant ferroélectrique accordable (52, 54) afin de réduire le décalage CC détecté, dans lequel la réduction du décalage CC et la production du signal de bande de base abaissé en fréquence ont lieu simultanément.

**FIG. 1**
PRIOR ART DIRECT
DOWNCONVERSION RECEIVER

EP 1 393 403 B1

FIG. 2

DIRECT DOWNCONVERSION RECEIVER

EP 1 393 403 B1

EP 1 393 403 B1

**FIG. 3**

**FIG. 5**

FIG. 4